# EUROPEAN PATENT SPECIFICATION

(11) **EP 1 729 554 B1**
(45) Date of publication and mention of the grant of the patent: **22.05.2013**
(21) Application number: 05255034.0
(22) Date of filing: 15.08.2005
(51) Int. Cl.: H05K 3/34, H01L 21/60

(54) **Soldering method and part-exchanging method**
Lötverfahren und Bauteilaustauschverfahren
Méthode de soudure et méthode d'échange de composants

(30) Priority: 31.05.2005 JP 2005159837
(43) Date of publication of application: 06.12.2006
(73) Proprietor: FUJITSU LIMITED, Kawasaki-shi, Kanagawa 211-8588 (JP)
(72) Inventor: Yamamoto, Tsuyoshi, c/o Fujitsu Limited, Kawasaki-shi, Kanagawa 211-8588 (JP); Hiruma, Akiomi, c/o Fujitsu Limited, Kawasaki-shi, Kanagawa 211-8588 (JP); Koyama, Fumigi, c/o Fujitsu Limited, Kawasaki-shi, Kanagawa 211-8588 (JP)
(74) Representative: Fenlon, Christine Lesley

(56) References cited:
- JP-A- 5 110 268
- JP-A- 6 196 838
- JP-A- 11 026 654
- JP-A- 62 252 155
- JP-A- 2003 188 522
- US-A- 5 060 114

## Description

### BACKGROUND OF THE INVENTION

### 1. Field of the Invention

The present invention relates to a soldering method and a part-exchanging method, and particularly, to a soldering method and a part-exchanging method suitable for soldering by using a Pb-free solder.

### 2. Description of the Related Art

In recent and continuing years, along with further progress in compactness and high performance of electronic devices, significant technical progress has been made in compactness of electronic parts installed in the electronic device, an installation device for installing the electronic parts on a substrate, and an installation method. Especially, as a technique of installing the electronic part on the substrate by soldering, a reflow soldering technique is frequently used to install electronic parts on the substrate at high density. For this technique, for example, reference can be made to Japanese Laid Open Patent Application No. 2003-188522.

In the reflow soldering technique, a soldering paste is applied on a substrate at a position where the electronic part is to be soldered. Next, a connection terminal of the part to be installed is temporarily fixed on the soldering paste, and the soldering paste is melted by heat. Due to this, an external connection terminal is soldered on the substrate, thereby, the electronic part is mounted on the surface of the substrate.

This reflow soldering technique is useful for surface-mounting, and is suitable for mounting at high density. In addition, heating in an electronic furnace is employed to heat in this technique. Further, the soldering temperature is specified appropriately based on the melting temperature of the solder and the heat-resistance of plural electronic parts which are mounted on a circuit board.

However, in recent years and continuing, a Pb-free solder is being used more and more to replace the solder of the related art, which includes Pb. The Pb-free solder has a melting temperature higher than that of the solder including Pb; hence, the heat-resistance of the electronic parts conforming to the conventional standard becomes approximately the same as or lower than the melting temperature of the Pb-free solder. For this reason, it is not easy to control the heating temperature during the reflow process, and it is difficult to mount the electronic parts by using the Pb-free solder. In the afore-mentioned reflow soldering technique of JP-A-2003-188522 damage to the electronic part being mounted is prevented by disposing a removable heat absorbing device comprising a silicon sheet on the electronic part.

Further, after the electronic parts are mounted, if it is found that an electronic part is faulty, this electronic part is exchanged. When exchanging the electronic part, similarly, the electronic part mounted on the substrate is heated to melt the solder at the soldering location. Therefore, the same problem occurs in the exchanging process as in the original mounting process.

### SUMMARY OF THE INVENTION

It is a general object of the present invention to solve one or more of the problems of the related art.

It is a more specific object of the present invention to provide a soldering method able to prevent occurrence of heat damage to an electronic part mounted by using a Pb-free solder having a high melting temperature, and a part-exchanging method.

According to a first aspect of the present invention, there is provided a soldering method for soldering an electronic part on a substrate by reflow soldering, comprising the steps of : applying a solder paste on the substrate; mounting the electronic part on the substrate by using the solder paste; disposing a heat capacity enhancing member on the electronic part, said heat capacity enhancing member including a material able to enhance a heat capacity of the electronic part; and soldering the electronic part onto the substrate by the reflow soldering with the heat capacity enhancing member being applied on the electronic part; characterised in that the said heat capacity enhancing material is a gel-like material and the specific heat, heat conductivity, volume and thickness of the heat capacity enhancing member are selected according to a shape and a heat-resistant temperature distribution of the electronic part.

According to the present invention, a heat capacity enhancing member, which includes a gel-like material able to enhance the heat capacity of the electronic part, is disposed on the electronic part. Hence, when soldering the electronic part on the substrate by reflow soldering, even when the electronic part is heated, because the heat capacity of the electronic part is enhanced by the heat capacity enhancing member, the electronic part is protected by the large heat capacity. Due to this, even when the electronic part is heated to a temperature equal to or higher than the heat-resistance of the electronic part, heat damage to the electronic part does not occur, and it is possible to prevent unreliable mounting of the electronic part on the substrate caused by insufficient heating.

According to the present invention, because the volume and thickness of the heat capacity enhancing member are changeable according to the shape and the heat-resistant temperature distribution of the electronic part, the heat capacity enhancing member can be changed appropriately according to the soldering temperature and the heat-resistant temperature of the electronic part; thereby, it is possible to enhance the degree of freedom of setting the soldering temperature.

US-A-5060114 discloses a conformable pad of silicone gel for conducting heat away from a packaged electronic power device with which it is in contact. JP-A-62-252155 discloses the use of silicone gel to cover a semiconductor chip before the device is sealed with silicone resin. However, neither document relates to soldering methods.

As an embodiment, in the step of soldering, according to a surface temperature distribution of the electronic part, the thickness of the heat capacity enhancing member is set large in a peripheral portion, and the thickness of an inner portion of the heat capacity enhancing member is set smaller that the thickness of the peripheral portion of the heat capacity enhancing member, said peripheral portion having a high surface temperature, and said inner portion having a low surface temperature.

According to the present invention, by adjusting the thickness of the heat capacity enhancing member according to the surface temperature distribution of the electronic part during the heating process, it is possible to make the surface temperature distribution of the electronic part be uniform when heating, and this facilitates temperature control during the reflow soldering. Further, it is possible to prevent defects in the electronic parts due to heating.

As an embodiment, the heat capacity enhancing member includes a silicone gel.

According to the present invention, the heat capacity enhancing member may be a silicone gel. Because the silicone gel is reusable even after being heated, this is quite economical.

As an embodiment, in the step of applying a solder paste, the solder paste includes a Pb-free solder.

According to the present invention, the Pb-free solder is used, and usage of the Pb-free solder can improve the safety level to the human body and to the environment.

As an embodiment, in the step of disposing the gel-like heat capacity enhancing member, a dispenser is used to dispose the gel-like heat capacity enhancing member on the electronic part.

According to the present invention, because the dispenser is used to dispose the gel-like heat capacity enhancing member on the electronic part, it is possible to efficiently dispose the gel-like heat capacity enhancing member on the electronic part.

As an embodiment, the heat capacity enhancing member is formed in a sheet shape before being disposed, and the sheet of the heat capacity enhancing member is disposed on the electronic part.

According to the present invention, because the heat capacity enhancing member is sheet-like, it is possible to easily handle the heat capacity enhancing member and dispose the heat capacity enhancing member on the electronic part.

According to a second aspect of the present invention, there is provided a part-exchanging method for exchanging at least one electronic part mounted on a substrate on which a plurality of the electronic parts is mounted on a surface of the substrate, comprising the steps of: disposing a heat capacity enhancing member on the electronic parts around the electronic part to be exchanged, said heat capacity enhancing member including a material able to enhance a heat capacity of the electronic parts; and heating the electronic part to be exchanged and removing the electronic part to be exchanged from the substrate; characterised in that the heat capacity enhancing material is a gel-like material and the specific heat, heat conductivity, volume and thickness of : the heat capacity enhancing member are selected according to a shape and a heat-resistant temperature distribution of the electronic parts.

According to the present invention, when heating the electronic part to be exchanged, because a heat capacity enhancing member is disposed on the electronic parts around the electronic part to be exchanged, it is possible to prevent heat damage to these electronic parts when exchanging that electronic part.

As an embodiment, the heat capacity enhancing member includes a silicone gel. As another embodiment, the heat capacity enhancing member is disposed also on the electronic part to be exchanged.

These and other objects, features, and advantages of the present invention will become more apparent from the following detailed description of the preferred embodiments given with reference to the accompanying drawings.

### BRIEF DESCRIPTION OF THE DRAWINGS

FIG. 1 is a flowchart illustrating a soldering method according to an embodiment of the present invention;
FIG. 2A through FIG. 2C are cross-sectional views for explaining the step S10 of printing a solder paste on a substrate according to the present embodiment;
FIG. 3A through FIG. 3C are cross-sectional views for explaining the step S12 of mounting an electronic part on the substrate according to the present embodiment;
FIG. 4A through FIG. 4C are cross-sectional views for explaining the step S14 of disposing a silicone gel on the electronic part according to the present embodiment;
FIG. 5A through FIG. 5C are cross-sectional views for explaining the step S16 of reflow soldering according to the present embodiment;
FIG. 6A through FIG. 6C are cross-sectional views for explaining the step S18 of stripping the silicone gel 18 according to the present embodiment;
FIG. 7A through FIG. 7C are cross-sectional views and graphs illustrating distributions of the surface temperatures of the semiconductor devices 12A, 12B, and 12C depending upon presence or absence of the silicone gel 18 or the method of disposing the silicone gel 18 in the reflow soldering process;
FIG. 8 is a table presenting data of the surface temperature, joint terminal temperature, and the substrate temperature of the QFP-type semiconductor device, the BGA-type semiconductor device, and the LQFP-type semiconductor device, the data being measured in a reflow soldering process when soldering the semiconductor devices by using the soldering method of the present embodiment;
FIG. 9A through FIG. 9D are cross-sectional views illustrating a method of exchanging a part according to an embodiment of the present invention; and
FIG. 10 is a cross-sectional view illustrating a method of exchanging a part as a modification of the method shown in FIG. 9A through FIG. 9D.

### DESCRIPTION OF THE PREFERRED EMBODIMENTS

Below, preferred embodiments of the present invention will be explained with reference to the accompanying drawings.

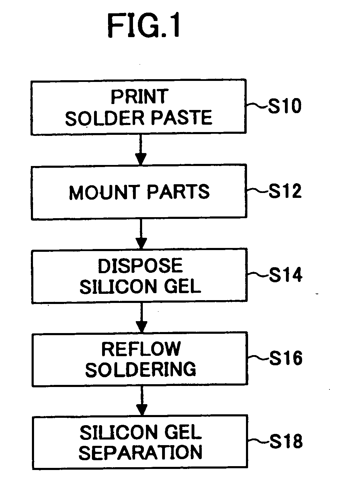

FIG. 1 is a flowchart illustrating a soldering method according to an embodiment of the present invention.

As illustrated in FIG. 1, the soldering method of the present embodiment includes a step of printing a solder paste on a substrate (S10), a step of mounting an electronic part on the substrate (S12), a step of disposing a silicone gel on the electronic part (S14), a step of reflow soldering (S16), and a step of silicone gel separation (S18).

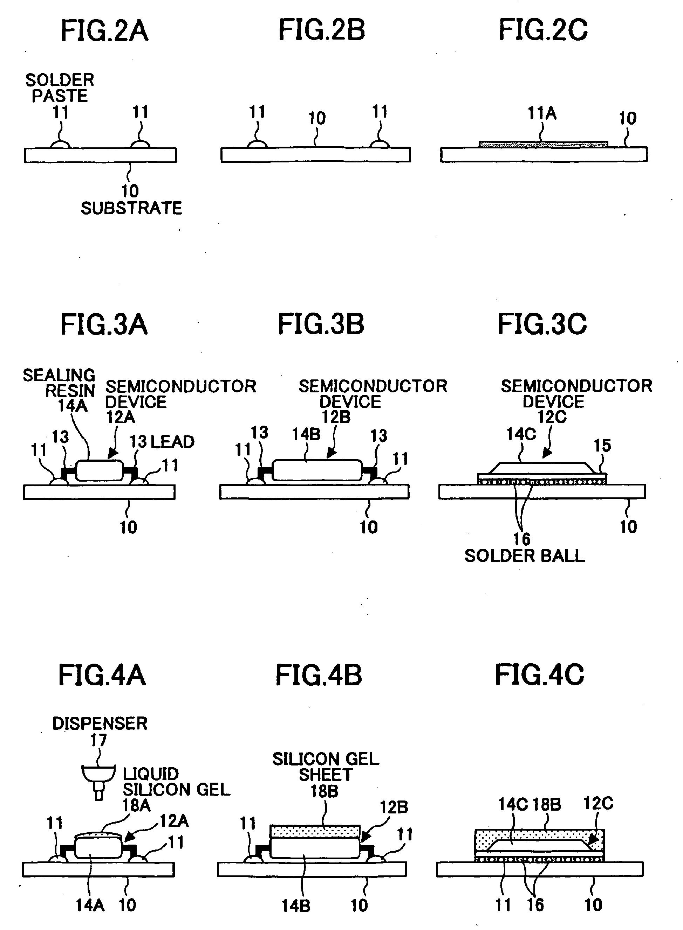

Below, the soldering method shown in FIG. 1 is explained with reference to FIG. 2 through FIG. 6.

Note that in FIG. 2A, FIG. 3A, FIG. 4A, FIG. 5A, and FIG. 6A, a QFP-type semiconductor device is used as an example of the electronic part, and a liquid silicone gel 18A is used as an example of a silicone gel 18; in FIG. 2B, FIG. 3B, FIG. 4B, FIG. 5B, and FIG. 6B, a QFP-type semiconductor device is used as an example of the electronic part, and a silicone gel sheet 18B is used as an example of the silicone gel 18; and in FIG. 2C, FIG. 3C, FIG. 4C, FIG. 5C, and FIG. 6C, a BGA-type semiconductor device is used as an example of the electronic part, and a silicone gel sheet 18B is used as an example of the silicone gel 18.

FIG. 2A through FIG. 2C are cross-sectional views for explaining step S10 of printing a solder paste on a substrate according to the present embodiment.

In FIG. 2A and FIG. 2B, which illustrate processes of soldering QFP-type semiconductor devices 12A and 12B (refer to FIG. 3A and FIG. 3B), respectively, a soldering paste 11 is printed on a substrate 10.

In FIG. 2C, which illustrates a process of soldering a BGA-type semiconductor device 12C (refer to FIG. 3C), a soldering paste 11A is printed on the substrate 10.

The step S10 of printing a solder paste, for example, can be performed by screen printing. Here, the solder included in the solder paste 11 or 11A is a Pb-free solder. Usage of the Pb-free solder improves the safety level to the human body and to the environment. The Pb-free solder is characterized in that is has a melting temperature higher than that of the Tin-Pb eutectic solder in the related art.

FIG. 3A through FIG. 3C are cross-sectional views for explaining step S12 of mounting an electronic part on the substrate according to the present embodiment.

After step S10 of printing a solder paste, step S12 is executed to mount the electronic part on the substrate.

FIG. 3A and FIG. 3B illustrate processes of mounting QFP-type semiconductor devices 12A and 12B, respectively. In FIG. 3A and FIG. 3B, a lead 13 sticks out of the periphery of the sealing resin 14A or 14B like a gull-wing. The lead 13 is stuck into the solder paste 11, which is printed on the substrate 10, and thereby, the semiconductor device 12A or 12B is tentatively fixed on the substrate 10.

FIG. 3C illustrates a process of mounting a BGA-type semiconductor device 12C. In the semiconductor device 12C in FIG. 3C, a semiconductor element is placed in a sealing resin 14C formed on the upper portion of the interposer substrate 15, and solder balls 16 are formed on the lower portion of the interposer substrate 15 to act as external connection terminals. When the solder paste 11A printed on the substrate is compressed in between the solder balls 16, the semiconductor device 12C is tentatively fixed on the substrate 10.

Here, the solder used to form the solder balls 16 is a Pb-free solder.

FIG. 4A through FIG. 4C are cross-sectional views for explaining step S14 of disposing a silicone gel on the electronic part according to the present embodiment.

After the step S12 of mounting the electronic part, step S14 is executed to dispose a silicone gel on the electronic part.

In FIG. 4A, FIG. 4B, and FIG. 4C, a silicone gel 18 (such as liquid silicone gel 18A or a silicone gel sheet 18B) is disposed on each of the semiconductor devices 12A, 12B, 12C. The silicone gel 18 corresponds to the heat capacity enhancing member in claims.

As illustrated in FIG. 4A, a dispenser 17 is used to dispose the liquid silicone gel 18A on the sealing resin 14A in the semiconductor device 12A, While, in FIG. 4B and FIG. 4C, the silicone gel sheet 18B is pasted on the sealing resin 14B and 14C in the semiconductor device 12B and 12C, respectively.

Here, the silicone gel 18 (such as, the liquid silicone gel 18A, and the silicone gel sheet 18B), is a silicone material having high heat-resistance, and is formed by including silica into silicone. The silicone gel 18 is in a gel state, thus having good elasticity, adhesiveness, strippability, and heat-resistance. In addition, with the inclusion of the silica being variable, the heat capacity of the silicone gel 18 is adjustable.

In the present embodiment, the heat capacity of the silicone gel 18 is adjusted so as to be greater than the heat capacities of the semiconductor devices 12A, 12B, and 12C, which are the electronic parts mounted on the substrate 10. In addition, because of the good heat-resistance, the silicone gel is reusable even after being heated.

The heat capacity of the silicone gel 18 is adjustable not only by adjusting the inclusion of the silica therein so as to adjust the specific heat and the heat conductivity thereof, but also by changing the volume of the silicone gel 18. When the heat conductivity of the silicone gel 18 is reduced, it is possible to achieve the adiabatic effect relative to the semiconductor devices 12A, 12B, and 12C, that is, preventing heat transfer. Therefore, when disposing the silicone gel 18 onto the semiconductor devices 12A, 12B, and 12C, the volume and the thickness of the silicone gel 18 can be appropriately adjusted according to the heat-resistant temperature distribution of the electronic part so that the heat capacity of the silicone gel 18 has an optimum value with respect to the semiconductor devices 12A, 12B, and 12C. For example, the optimum heat capacity of the silicone gel 18 ensures no heat damage occurs in the semiconductor devices 12A, 12B, and 12C. As a result, it is possible to enhance the degree of freedom of setting the soldering temperature in the following reflow soldering step S16.

As shown in FIG. 4A, because the liquid silicone gel 18A is disposed on the semiconductor device 12A by using the dispenser 17, the liquid silicone gel 18A can be disposed on the semiconductor devices 12A more efficiently.

In addition, as shown in FIG. 4B and FIG. 4C, because the silicone gel sheet 18B is formed in advance, and then the silicone gel sheet 18B is pasted on the semiconductor device 12B or 12C, the silicone gel 18 can be handled easily, and the silicone gel 18 can be disposed on the semiconductor device 12B or 12C easily.

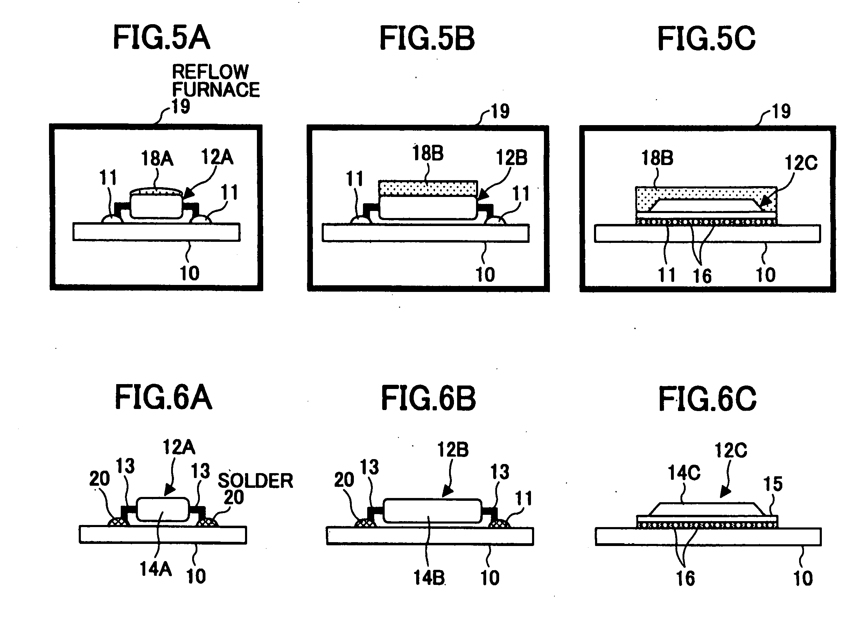

FIG. 5A through FIG. 5C are cross-sectional views for explaining step S16 of reflow soldering according to the present embodiment.

After the step S14 of disposing the silicone gel on the semiconductor device 12A, 12B, or 12C, step S16 is executed to perform reflow soldering.

As shown in FIG. 5A, FIG. 5B, and FIG. 5C, the semiconductor device 12A, 12B, or 12C are set in a reflow furnace 19.

As described above, in the present embodiment, before performing reflow soldering, the silicone gel 18 (such as liquid silicone gel 18A or a silicone gel sheet 18B) is disposed on the semiconductor device 12A, 12B, or 12C. Due to this, the semiconductor device 12A, 12B, or 12C is protected by the large heat capacity of the silicone gel 18 even when being heated.

For this reason, even when the semiconductor device 12A, 12B, or 12C is heated to a temperature at which the Pb-free solder may be melted, that is, a temperature equal to or higher than the heat-resistance of the semiconductor device 12A, 12B, or 12C, because of the presence of the silicone gel 18, heat transfer to the semiconductor device 12A, 12B, or 12C is preventable. As a result, heat damage to the semiconductor device 12A, 12B, or 12C does not occur, and it is possible to prevent unreliable mounting of the semiconductor device 12A, 12B, or 12C on the substrate 10 caused by insufficient heating.

FIG. 6A through FIG. 6C are cross-sectional views for explaining step S18 of stripping the silicone gel 18 according to the present embodiment.

After the step S16 of reflow soldering on the semiconductor device 12A, 12B, or 12C, step S18 is executed to strip the silicone gel 18 from the substrate 10.

As shown in FIG. 6A, FIG. 6B, and FIG. 6C, the silicone gel 18 (such as liquid silicone gel 18A or a silicone gel sheet 18B) is stripped from the semiconductor device 12A, 12B, or 12C.

After the silicone gel 18 is stripped, organic components included in the solder paste 11 or 11A are vaporized, and the lead 13 of the semiconductor device 12A or 12B is joined to the substrate 10 by the solder 20, or the semiconductor device 12C is joined to the substrate 10 by the solder balls 16.

The silicone gel 18 stripped from the semiconductor device 12A, 12B, or 12C can be used again even after being heated, because the silicone gel 18 has good heat-resistance, and this reduces the running cost of the soldering method of the present embodiment.

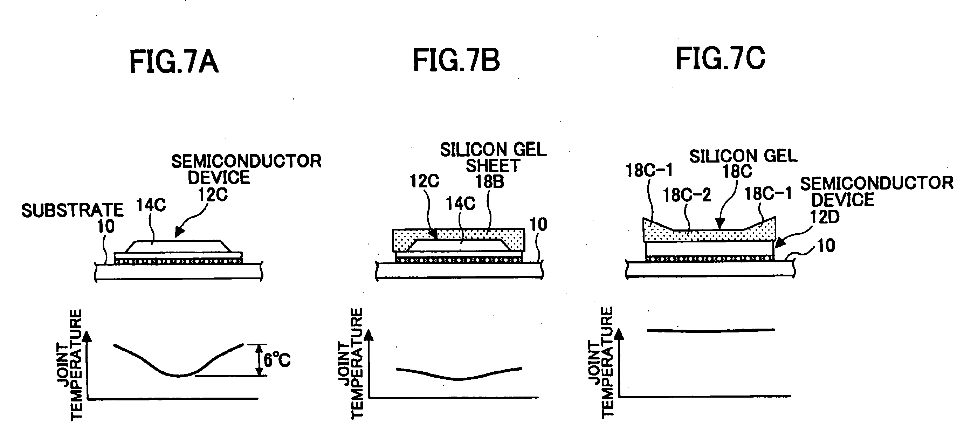

FIG. 7A through FIG. 7C are cross-sectional views and graphs illustrating distributions of the surface temperatures of the semiconductor device 12A, 12B, and 12C depending upon presence or absence of the silicone gel 18 or the method of disposing the silicone gel 18 in the reflow soldering process.

Note that in FIG. 7A through 7C, a BGA-type semiconductor device 12C is used as an example of the electronic part.

FIG. 7A shows the distribution of the surface temperature of the sealing resin 14C without disposing the silicone gel 18 in the reflow soldering process. As illustrated in FIG. 7A, the surface temperature at the peripheral portion of the semiconductor device 12C is higher than the surface temperature at the center portion of the semiconductor device 12C.

FIG. 7B shows the distribution of the surface temperature of the sealing resin 14C with a silicone gel sheet 18C having a uniform thickness being disposed on the semiconductor device 12C in the reflow soldering process. As illustrated in FIG. 7B, the surface temperature of the sealing resin 14C decreases overall compared to the case in FIG. 7A in which the silicone gel 18 is absent. However, the surface temperature at the peripheral portion of the semiconductor device 12C is still higher than the surface temperature at the center portion of the semiconductor device 12C.

FIG. 7C shows the distribution of the surface temperature of a semiconductor device 12D in the reflow soldering process on the semiconductor device 12D, where a silicone gel sheet 18C has a modulated non-uniform thickness. Here, the thickness of the silicone gel sheet 18C is modulated according to a surface temperature distribution of a bare semiconductor device 12D which is measured in advance in the reflow soldering process. Specifically, because the surface temperature at the peripheral portion is expected to be high, the thickness of the peripheral portion 18C-1 of the silicone gel sheet 18D is set to be large; and because the surface temperature at the inner portion is expected to be low, the thickness of the inner portion 18C-2 of the silicone gel sheet 18D is set to be less than the thickness of the peripheral portion 18C-1.

With the thickness of the silicone gel sheet 18C being modulated in this way, and with such a silicone gel sheet 18C being disposed on the semiconductor device 12D, in the reflow soldering process of the semiconductor device 12D, as illustrated in FIG. 7C, the surface temperature of the semiconductor device 12D is essentially uniform. Due to this, it is easy to control the heating temperature during the reflow process, and it is possible to prevent defects in the semiconductor device 12D caused by heating.

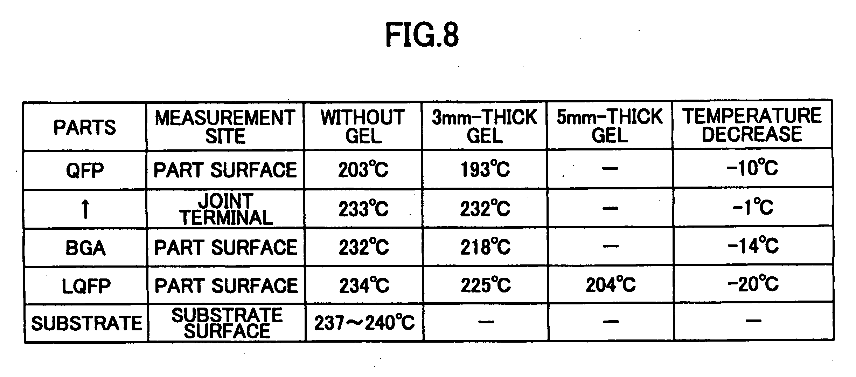

FIG. 8 is a table presenting measured data of surface temperature, joint terminal temperature, and the substrate temperature of the QFP-type semiconductor device, the BGA-type semiconductor device, and the LQFP-type semiconductor device, the data being measured in a reflow soldering process when soldering the semiconductor devices by using the soldering method of the present embodiment.

As shown in the fourth column of the table in FIG. 8, in the QFP-type semiconductor device and the BGA-type semiconductor device, when a 3 mm-thick silicone gel 18 is disposed, the surface temperature is lowered by about 10 °C. In addition, in the LQFP-type semiconductor device, when a 3 mm-thick silicone gel 18 is disposed, the surface temperature is lowered by about 9 °C, and the surface temperature turns to be 225 °C. However, the LQFP-type semiconductor device used in this experiment has a heat resistance temperature equaling (225 °C ± 5 °C), which is relatively low; hence, even at 225 °C, the reliability of the LQFP-type semiconductor device is not guaranteed. has a heat resistance temperature equaling (225 °C ± 5 °C), which is relatively low; hence, even at 225 °C, the reliability of the LQFP-type semiconductor device is not guaranteed.

As shown in the fifth column of the table in FIG. 8, when a 5 mm-thick silicone gel 18 is disposed, the LQFP surface temperature is additionally lowered by about 5 °C, and the surface temperature of the LQFP-type semiconductor device is lowered to 204 °C.

In other words, according to the soldering method of the present embodiment, even when the heat resistance of the electronic part is low, it is possible to execute the reflow soldering process while maintaining the temperature of the electronic part below a certain value.

As for the BGA-type semiconductor device having joint terminals arranged in a plane, the joint temperature at the peripheral portion is usually quite different from the joint temperature at the inner portion. For example, considering a plastic BGA-type semiconductor device having 354 pins, the temperature difference between the peripheral portion and the inner portion is about 6 °C. This temperature difference can also be cancelled by modulating the thickness of the silicon gel 18 to make the temperature distribution uniform.

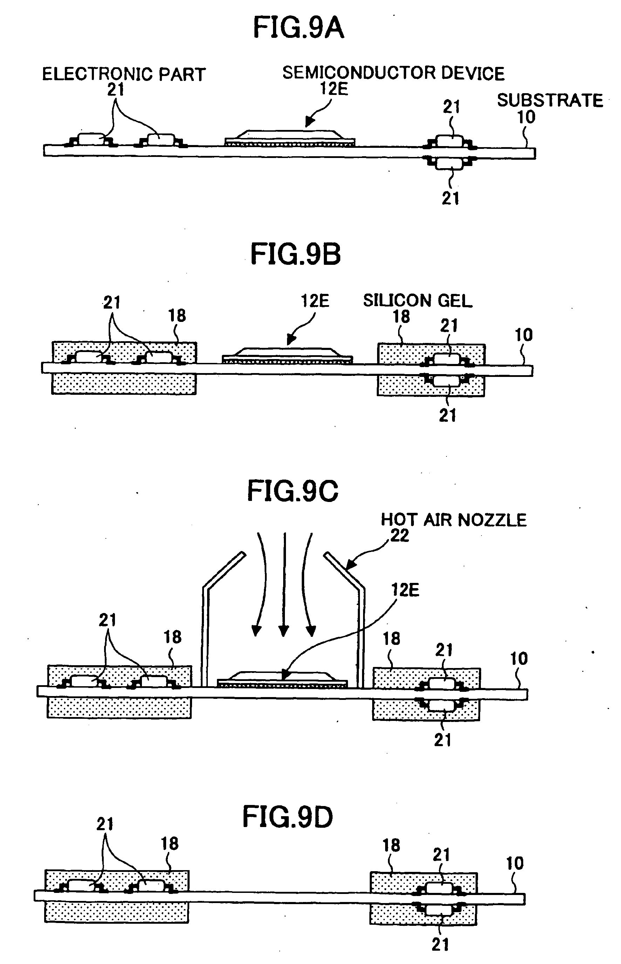

FIG. 9A through FIG. 9D are cross-sectional views illustrating a method of exchanging a part according to an embodiment of the present invention.

In the part-exchanging method shown in FIG. 9A through FIG. 9D, an electronic part (a semiconductor device 12E in this example), which is mounted by soldering, is removed from the substrate 10. This removing process is performed when defects are found in the semiconductor device 12E, which has been mounted on the substrate 10 by soldering, and it is necessary to exchange the semiconductor device 12E.

As illustrated in FIG. 9A, in addition to the semiconductor device 12E, many other electronic parts 21 are also mounted on the substrate 10. When exchanging the semiconductor device 12E, it is required to only remove the semiconductor device 12E from the substrate 10 but not to cause damage to the other electronic parts 21.

In the part-exchanging method of the present embodiment, as shown in FIG. 9B, the silicone gel 18 is disposed on the other electronic parts 21, which ought to remain at their positions. The silicone gel 18 is selected to be formed from a material having a heat capacity larger than that of the electronic parts 21. In addition, the silicone gel 18 is disposed when heating the semiconductor device 12E for exchanging, and only on the other electronic parts 21 arranged around the semiconductor device 12E whose temperature is to increase due to its being heated.

After the silicone gel 18 is disposed on the other electronic parts 21, as illustrated in FIG. 9C, a hot air nozzle 22 is attached to the semiconductor device 12E. The hot air nozzle 22 is able to blow the heated air inside. In the process of blowing, the temperature inside the hot air nozzle 22 is set sufficiently high so as to melt the solder, which fixes the semiconductor device 12E to the substrate 10. With the solder being melted, the silicone gel 18 being selected to be larger than that of the electronic parts 21. Due to this, it is possible to prevent heat damage to these electronic parts 21 when heating the semiconductor device 12E for removing the semiconductor device 12E from the substrate 10.

After the semiconductor device 12E is removed from the substrate 10, next, the silicone gel 18 is stripped from the other electronic parts 21. As described above, the silicone gel 18 can be used again.

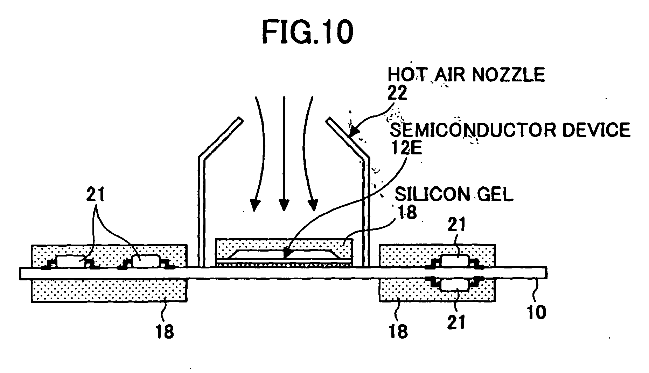

FIG. 10 is a cross-sectional view illustrating a method of exchanging a part as a modification of the method shown in FIG. 9A through FIG. 9D.

In the above, it is described that the silicone gel 18 is disposed only on the other electronic parts 21 arranged around the semiconductor device 12E to be removed. However, as shown in FIG. 10, the silicone gel 18 can also be disposed on the semiconductor device 12E to be removed. In doing so, it is possible to remove the semiconductor device 12E from the substrate 10 without causing damage to the semiconductor device 12E. This method is useful, for example, when the solder balls 16 do not make good connection with the substrate, but the semiconductor device 12E is in good condition.

According to the present invention, a heat capacity enhancing member, which includes a gel-like material able to enhance the heat capacity of an electronic part, is disposed on the electronic part. Hence, when soldering the electronic part onto the substrate by reflow soldering, even though the electronic part is heated, because the heat capacity of the electronic part is enhanced by the heat capacity enhancing member, the electronic part is protected by the large heat capacity. Due to this, even when the electronic part is heated to a temperature equal to or higher than the heat-resistance of the electronic part, heat damage to the electronic part does not occur, while it is possible to prevent unreliable mounting of the electronic part to the substrate caused by insufficient heating.

While the invention is described above with reference to specific embodiments chosen for purpose of illustration, it should be apparent that the invention is not limited to these embodiments, but numerous modifications could be made thereto by those skilled in the art without departing from the basic concept and scope of the invention.

## Claims

1. A soldering method for soldering an electronic part (12A, 12B, 12C) on a substrate (10) by reflow soldering, comprising the steps of:
applying a solder paste (11, 11A) on the substrate (10);
mounting the electronic part (12A, 12B, 12C) on the substrate (10) by using the solder paste (11, 11A) ;
disposing a heat capacity enhancing member (18A, 18B) on the electronic part (12A, 12B, 12C), said heat capacity enhancing member (18A, 18B) including a material able to enhance a heat capacity of the electronic part (12A, 12B, 12C) ; and
soldering the electronic part (12A, 12B, 12C) onto the substrate (10) by the reflow soldering with the heat capacity enhancing member (18A, 18B) being applied on the electronic part (12A, 12B, 12C);
**characterised in that** the said heat capacity enhancing material is a gel-like material and the specific heat, heat conductivity, volume and thickness of the heat capacity enhancing member (18A, 18B) are selected according to a shape and a heat-resistant temperature distribution of the electronic part (12A, 12B, 12C).

2. The soldering method as claimed in claim 1, wherein
in the step of soldering, according to a surface temperature distribution of the electronic part (12A, 12B, 12C), the thickness of the heat capacity enhancing member (18A, 18B) is set large in a peripheral portion, and the thickness of an inner portion of the heat capacity enhancing member (18A, 18B) is set smaller that the thickness of : the peripheral portion of the heat capacity enhancing member (18A, 18B), said peripheral portion having a high surface temperature, and said inner portion having a low surface temperature.

3. The soldering method as claimed in claim 1, wherein the heat capacity enhancing member (18A, 18B) includes a silicone gel.

4. The soldering method as claimed in claim 1, wherein
in the step of applying a solder paste (11, 11A), the solder paste (11, 11A) includes a Pb-free solder.

5. The soldering method as claimed in claim 1, wherein in the step of disposing the gel-like heat capacity enhancing member (18A, 18B), a dispenser (17) is used to dispose the gel-like heat capacity enhancing member (18A, 18B) on the electronic part (12A, 12B, 12C).

6. The soldering method as claimed in claim 1, wherein
the heat capacity enhancing member (18A, 18B) is formed in a sheet shape before the step of disposing the gel-like heat capacity enhancing member (18A, 18B) ; and
in the step of disposing the gel-like heat capacity enhancing member (18A, 18B), the sheet of the heat capacity enhancing member (18A, 18B) is disposed on the electronic part (12A, 12B, 12C).

7. A part-exchanging method for exchanging at least one electronic part (12E) mounted on a substrate (10) on which a plurality of the electronic parts (21) is mounted on a surface of the substrate (10), comprising the steps of:
disposing a heat capacity enhancing member (18) on the electronic parts (21) around the electronic part (12E) to be exchanged, said heat capacity enhancing member (18) including a material able to enhance a heat capacity of the electronic parts (21) ; and
heating the electronic part (12E) to be exchanged and removing the electronic part (12E) to be exchanged from the substrate (10);
**characterised in that** the heat capacity enhancing material (18) is a gel-like material and the specific heat, heat conductivity, volume and thickness of the heat capacity enhancing member (18) are selected according to a shape and a heat-resistant temperature distribution of the electronic parts (21).

8. The part-exchanging method as claimed in claim 7, wherein the heat capacity enhancing member includes a silicone gel.

9. The part-exchanging method as claimed in claim 7, wherein in the step of disposing, the heat capacity enhancing member is also disposed on the electronic part to be exchanged.

## Patentansprüche

1. Lötverfahren zum Löten eines elektronischen Teils (12A, 12B, 12C) auf einem Substrat (10) durch Reflow-Löten, das die folgenden Schritte umfasst:
Auftragen einer Lötpaste (11, 11A) auf das Substrat (10);
Montieren des elektronischen Teils (12A, 12B, 12C) auf dem Substrat (10) durch Verwendung der Lötpaste (11, 11A) ;
Anordnen eines Elementes (18A, 18B) zur Vergrößerung der Wärmekapazität auf dem elektronischen Teil (12A, 12B, 12C), wobei das Element (18A, 18B) zur Vergrößerung der Wärmekapazität ein Material umfasst, das eine Wärmekapazität des elektronischen Teils (12A, 12B, 12C) vergrößern kann; und
Löten des elektronischen Teils (12A, 12B, 12C) auf dem Substrat (10) durch Reflow-Löten mit dem die Wärmekapazität vergrößernden Element (18A, 18B), das auf das elektronische Teil (12A, 12B, 12C) aufgebracht wird;
**dadurch gekennzeichnet, dass** das die Wärmekapazität vergrößernde Material ein gelartiges Material ist und die spezifische Wärme, Wärmeleitfähigkeit, Volumen und Dicke des die Wärmekapazität vergrößernden Elementes (18A, 18B) gemäß einer Form und einer wärmebeständigen Temperaturverteilung des elektronischen Teils (12A, 12B, 12C) gewählt werden.

2. Lötverfahren nach Anspruch 1, wobei
beim Schritt des Lötens gemäß einer Oberflächentemperaturverteilung des elektronischen Teils (12A, 12B, 12C) die Dicke des die Wärmekapazität vergrößernden Elementes (18A, 18B) in einem peripheren Abschnitt groß eingestellt wird und die Dicke eines inneren Abschnitts des die Wärmekapazität vergrößernden Elementes (18A, 18B) kleiner als die Dicke des peripheren Abschnitts des die Wärmekapazität vergrößernden Elementes (18A, 18B) eingestellt wird, wobei der periphere Abschnitt eine hohe Oberflächentemperatur hat und der innere Abschnitt eine niedrige Oberflächentemperatur hat.

3. Lötverfahren nach Anspruch 1, wobei das die Wärmekapazität vergrößernde Element (18A, 18B) ein Silikongel umfasst.

4. Lötverfahren nach Anspruch 1, wobei
beim Schritt des Auftragens einer Lötpaste (11, 11A) die Lötpaste (11, 11A) ein Pb-freies Lot umfasst.

5. Lötverfahren nach Anspruch 1, wobei im Schritt des Verteilens des gelartigen, die Wärmekapazität vergrößernden Elementes (18A, 18B) eine Dosiervorrichtung (17) zum Verteilen des gelartigen, die Wärmekapazität vergrößernden Elementes (18A, 18B) auf dem elektronischen Teil (12A, 12B, 12C) verwendet wird.

6. Lötverfahren nach Anspruch 1, wobei
das die Wärmekapazität vergrößernde Element (18A, 18B) vor dem Schritt des Verteilens des gelartigen, die Wärmekapazität vergrößernden Elementes (18A, 18B) in Folienform gebildet wird; und
beim Schritt des Verteilens des gelartigen, die Wärmekapazität vergrößernden Elementes (18A, 18B) der Belag des die Wärmekapazität vergrößernden Elementes (18A, 18B) auf dem elektronischen Teil (12A, 12B, 12C) verteilt wird.

7. Teilaustauschverfahren zum Auswechseln von mindestens einem elektronischen Teil (12E), das auf einem Substrat (10) befestigt ist, auf dem mehrere elektronische Teile (21) auf einer Fläche des Substrats (10) befestigt sind, das die folgenden Schritte umfasst:
Verteilen eines die Wärmekapazität vergrößernden Elementes (18) auf den elektronischen Teilen (21) um das elektronische Teil (12E) herum, das ausgewechselt werden soll, wobei das die Wärmekapazität vergrößernde Element (18) ein Material umfasst, das die Wärmekapazität der elektronischen Teile (21) vergrößern kann; und
Erwärmen des elektronischen Teils (12E), das ausgewechselt werden soll, und Entfernen des elektronischen Teils (12E), das ausgewechselt werden soll, vom Substrat (10) ;
**dadurch gekennzeichnet, dass** das die Wärmekapazität vergrößernde Material (18) ein gelartiges Material ist und die spezifische Wärme, Wärmeleitfähigkeit, Volumen und Dicke des die Wärmekapazität vergrößernden Elementes (18) gemäß einer Form und einer wärmebeständigen Temperaturverteilung der elektronischen Teile (21) gewählt werden.

8. Teilaustauschverfahren nach Anspruch 7, wobei das die Wärmekapazität vergrößernde Element ein Silikongel umfasst.

9. Teilaustauschverfahren nach Anspruch 7, wobei beim Schritt des Verteilens das die Wärmekapazität vergrößernde Element auch auf dem elektronischen Teil verteilt wird, das ausgewechselt werden soll.

## Revendications

1. Procédé de soudage pour souder un composant électronique (12A, 12B, 12C) sur un substrat (10) par soudage par fusion, comprenant les étapes consistant à:
appliquer une pâte à souder (11, 11A) sur le substrat (10);
monter le composant électronique (12A, 12B, 12C) sur le substrat (10) en utilisant la pâte à souder (11, 11A);
disposer un élément d'amélioration de capacité thermique (18A, 18B) sur le composant électronique (12A, 12B, 12C), ledit élément d'amélioration de capacité thermique (18A, 18B) comprenant un matériau pouvant améliorer une capacité thermique du composant électronique (12A, 12B, 12C); et
souder le composant électronique (12A, 12B, 12C) sur le substrat (10) par soudage par fusion avec l'élément d'amélioration de capacité thermique (18A, 18B) qui est appliqué sur le composant électronique (12A, 12B, 12C);
**caractérisé en ce que** ledit matériau d'amélioration de capacité thermique est un matériau de type gel et la chaleur spécifique, la conductivité thermique, le volume et l'épaisseur de l'élément d'amélioration de capacité thermique (18A, 18B) sont sélectionnés selon une forme et une répartition de température résistant à la chaleur du composant électronique (12A, 12B, 12C).

2. Procédé de soudage selon la revendication 1, dans lequel:
à l'étape de soudage, selon une répartition de température de surface du composant (12A, 12B, 12C), l'épaisseur de l'élément d'amélioration de capacité thermique (18A, 18B) est importante dans une partie périphérique, et l'épaisseur d'une partie interne de l'élément d'amélioration de capacité thermique (18A, 18B) est plus petite que l'épaisseur de la partie périphérique de l'élément d'amélioration de capacité thermique (18A, 18B), ladite partie périphérique ayant une température de surface élevée, et ladite partie interne ayant une température de surface basse.

3. Procédé de soudage selon la revendication 1, dans lequel l'élément d'amélioration de capacité thermique (18A, 18B) comprend un gel de silicone.

4. Procédé de soudage selon la revendication 1, dans lequel:
à l'étape d'application de pâte de soudage (11, 11A), la pâte de soudage (11, 11A) comprend une soudure dépourvue de Pb.

5. Procédé de soudage selon la revendication 1, dans lequel à l'étape de dépôt de l'élément d'amélioration de capacité thermique de type gel (18A, 18B), un distributeur (17) est utilisé pour déposer l'élément d'amélioration de capacité thermique de type gel (18A, 18B) sur le composant électronique (12A, 12B, 12C).

6. Procédé de soudage selon la revendication 1, dans lequel:
l'élément d'amélioration de capacité thermique (18A, 18B) est formé selon une forme de feuille avant l'étape consistant à déposer l'élément d'amélioration de capacité thermique de type gel (18A, 18B); et
à l'étape de dépôt d'élément d'amélioration de capacité thermique de type gel (18A, 18B), la feuille de l'élément d'amélioration de capacité thermique (18A, 18B) est déposée sur le composant électronique (12A, 12B, 12C).

7. Procédé d'échange de composants pour échanger au moins un composant électronique (12E) monté sur un substrat (10) sur lequel une pluralité des composants électroniques (21) est montée sur une surface du substrat (10), comprenant les étapes consistant à:
déposer un élément d'amélioration de capacité thermique (18) sur les composants électroniques (21) autour du composant électronique (12E) à échanger, ledit élément d'amélioration de capacité thermique (18) comprenant un matériau pouvant améliorer une capacité thermique des composants électroniques (21); et
faire chauffer le composant électronique (12E) à échanger et retirer le composant électronique (12E) à échanger du substrat (10);
**caractérisé en ce que** le matériau d'amélioration de capacité thermique (18) est un matériau de type gel et la chaleur spécifique, la conductivité thermique, le volume et l'épaisseur de l'élément d'amélioration de capacité thermique (18) sont sélectionnés selon une forme et une répartition de température résistant à la chaleur des composants électroniques (21).

8. Procédé d'échange de composants selon la revendication 7, dans lequel l'élément d'amélioration de capacité thermique comprend un gel de silicone.

9. Procédé d'échange de composants selon la revendication 7, dans lequel à l'étape de dépôt, l'élément d'amélioration de capacité thermique est également déposé sur le composant électronique à échanger.
